# DEMANDE DE BREVET EUROPEEN

(11) **EP 4 575 045 A1**
(43) Date de publication de la demande: **25.06.2025**
(21) Numéro de dépôt: 23217455.7
(22) Date de dépôt: 18.12.2023
(51) Int. Cl.: C25D 1/00

(54) **PROCÉDÉ DE FABRICATION DE COMPOSANTS HORLOGERS EN LOT**

(71) Demandeur: Nivarox-FAR S.A., 2400 Le Locle (CH)
(72) Inventeur: SALIHU, Fatmir, 2000 Neuchâtel (CH); BARFUSS, Philippe, 2012 Auvernier (CH); CUSIN, Pierre, 1423 Villars-Burquin (CH)
(74) Mandataire: ICB SA

(57) **Abrégé**

L'invention concerne un procédé de fabrication en lot de composants horlogers.

## Description

### Domaine technique de l'invention

La présente invention concerne un procédé de fabrication d'un lot de composants horlogers métalliques au moyen de la technologie LIGA.

### Arrière-plan technologique

On connaît déjà des procédés correspondant à la définition ci-dessus. En particulier, l'article d'A. B. Frazier et al. intitulé « Metallic Microstuctures Fabricated Using Photosensitive Polyimide Electroplating molds » et publié dans le journal of Microelectromechanical systems (Vol. 2, N deg. 2, June 1993) décrit un procédé pour la fabrication de structures métalliques multi-niveaux par croissance galvanique dans des moules de polyimide réalisés par photolithographie de couches de résine photosensible.

Ce procédé comprend les étapes suivantes :
- créer sur un substrat une couche métallique sacrificielle et une couche d'amorçage pour une étape ultérieure de croissance galvanique,
- étaler une couche de polyimide photosensible,
- irradier la couche de polyimide avec un rayonnement UV à travers un masque correspondant au contour d'un niveau de la structure à obtenir,
- développer la couche de polyimide en dissolvant les parties non irradiées de façon à obtenir un moule en polyimide,
- remplir le moule de nickel jusqu'à la hauteur de celui-ci par croissance galvanique, et obtenir une surface supérieure sensiblement plane,
- déposer une fine couche de chrome sur toute la surface supérieure par vaporisation sous vide,
- déposer sur la couche de chrome une nouvelle couche de résine photosensible,
- irradier la couche de résine à travers un nouveau masque correspondant au contour du niveau suivant de la structure à obtenir,
- développer la couche de polyimide de façon à obtenir un nouveau moule,
- remplir le nouveau moule de nickel jusqu'à la hauteur de celui-ci par croissance galvanique,
- séparer la structure multi-niveaux et le moule en polyimide de la couche sacrificielle et du substrat,
- séparer la structure multi-niveaux du moule en polyimide.

On comprendra que le procédé qui vient d'être décrit peut, en principe, être mis en oeuvre de manière itérative pour obtenir des structures métalliques ayant plus de deux niveaux.

Un tel procédé a pour inconvénient de donner lieu à de nombreuses pièces fabriquées en vrac, ce qui peut impliquer une détérioration des pièces due à des chocs, des coincements ou des emmêlements. Pour remédier à cet inconvénient, il est possible d'effectuer un tri des pièces mais cela reste coûteux et chronophage.

Un autre inconvénient d'un tel procédé est que lorsqu'il est nécessaire d'effectuer une ou plusieurs étapes de finition, un posage complexe est requis pour positionner les pièces individuellement de façon adéquate durant l'opération. Il faut alors réordonner les pièces pour chaque étape de finition, ce qui est également coûteux et chronophage.

### Résumé de l'invention

L'invention résout les inconvénients précités en proposant une solution permettant de garder les composants attachés entre eux via une grille, pour pouvoir les manipuler, les travailler et/ou les décorer en lot.

L'invention permet également de garder les composants attachés à la grille comme sur un wafer, tout en dégageant la face arrière pour pouvoir la travailler et/ou la décorer facilement sans avoir à mettre en oeuvre des moyens techniques complexes pour garder positionnés les composants individuellement, tout en les retournant pour réaliser une opération en face arrière. Le positionnement précis est indispensable, une fois les composants retournés, pour réaliser précisément l'opération de reprise mécanique envisagée.

A cet effet, la présente invention concerne un procédé de fabrication de composants horlogers en lot, caractérisé en ce qu'il comprend les étapes suivantes :
a) se munir d'un substrat recouvert d'une couche conductrice d'amorçage ;
b) appliquer sur la partie conductrice de la surface du substrat une couche de résine photosensible ;
c) irradier la couche de résine à travers un masque définissant le contour d'un lot de composants, ainsi qu'une grille et des ponts de matière, les ponts de matière reliant les composants à la grille au niveau d'une surface non fonctionnelle, la grille, les ponts de matière et les composants horlogers formant une grappe de composants ;
d) dissoudre les zones non irradiées de la couche de résine photosensible pour faire apparaître par endroit la surface conductrice du substrat et former un moule ;
e) déposer électro-galvaniquement et de manière conforme une couche métallique à partir de la couche conductrice, la couche métallique formant la grappe de composants et atteignant le niveau de la surface supérieure de la couche de résine photosensible ;
f) éliminer la couche de résine photosensible et le substrat pour libérer la grappe de composants ainsi formée ;
g) libérer le composant de la grappe.

Conformément à d'autres variantes avantageuses de l'invention :
- le procédé comprend une étape e') entre l'étape e) et l'étape f), au cours de laquelle on aplanit la couche de résine et la couche métallique déposée pour amener la couche de résine et la couche métallique électrodéposée au même niveau.
- le procédé comprend :
   - après l'étape d), répéter l'étape c) et d) au moins une fois pour obtenir un moule d'au moins deux niveaux ;
   - appliquer au moins une autre couche métallique sur l'au moins deuxième niveau du moule.
- le moule présente plusieurs niveaux ;
- le pont de matière présente une épaisseur identique à celle du composant ;
- le pont de matière présente une épaisseur inférieure à celle du composant ;
- le procédé comprend une étape g) de finition en wafer des faces avant, arrière et/ou latérales du composant horloger, l"étape de finition consistant en un dépôt de couches, de structuration et/ou de décoration par exemple ;
- la grappe de composants horlogers comprend un lot de mêmes composants choisis parmi : roue, came, aiguille, bascule, limaçon, masse oscillante, index ou applique ;
- la grappe de composants horlogers comprend un lot de composants différents tels que des roues, cames, aiguilles, bascules, masses oscillantes, limaçons, index ou appliques.

L'invention concerne également un lot ou une grappe de composants horlogers obtenu par la mise en oeuvre d'un procédé de fabrication conforme à l'invention.

### Brève description des figures

D'autres caractéristiques et avantages de l'invention apparaîtront à la lecture de la description détaillée suivante donnée à titre d'exemple nullement limitatif, en référence aux dessins annexés dans lesquels :
- la figure 1 représente schématiquement le procédé de fabrication conformément à l'invention ;

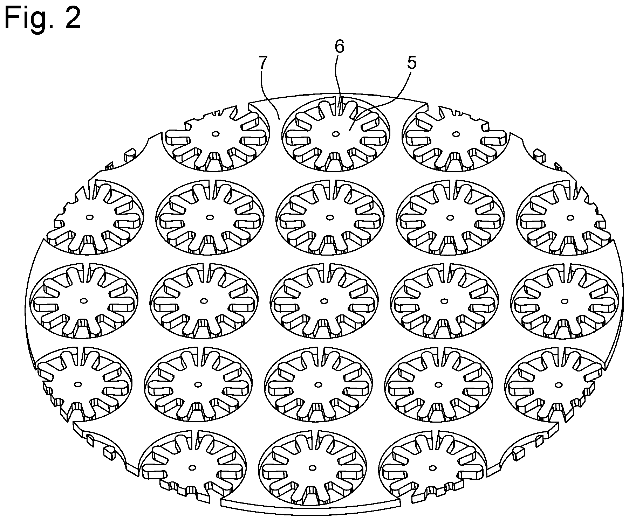

- la figure 2 illustre un exemple d'une grappe de composants obtenue via le procédé conformément à l'invention.

### Description détaillée de l'invention

L'invention se rapporte à un procédé de fabrication d'un composant horloger.

Par profil externe fonctionnel, on entend un composant horloger dont le pourtour extérieur du composant forme une surface fonctionnelle agencée pour coopérer avec d'autres pièces et/ou composants horlogers.

Le substrat 1 utilisé dans l'étape a) du procédé selon l'invention est, par exemple, formé par un substrat en silicium. Lors de la première étape a) du procédé on dépose, par exemple, par un dépôt physique en phase vapeur (PVD), une couche conductrice 2, c'est-à-dire une couche apte à démarrer un dépôt métallique par voie galvanique. Typiquement, la couche conductrice 2 est du type Au, Ti, Pt, Ag, Cr ou Pd, ou un empilement d'au moins deux de ces matériaux, et présente une épaisseur comprise entre 50nm et 500nm. Par exemple, la couche conductrice 2 peut être formée d'une sous couche de chrome ou de titane recouverte d'une couche d'or ou de cuivre.

La résine photosensible 3 utilisée dans ce procédé est de préférence une résine de type négative à base d'époxy octofonctionnelle conçue pour polymériser sous l'action d'un rayonnement UV.

Selon un mode de réalisation particulier de l'invention, la résine se présente sous la forme d'un film sec, la résine est alors appliquée par laminage sur le substrat 1.

Alternativement, la résine photosensible pourrait être un photorésist positif qui est conçu pour se décomposer sous l'action d'un rayonnement UV. On comprendra que la présente invention ne se limite pas à quelques types particuliers de résine photosensible. L'homme du métier saura choisir une résine photosensible convenant à ses besoins parmi toutes les résines connues qui sont adaptées à la photolithographie par UV.

Lors de l'étape b), une couche de résine 3 est déposée sur le substrat 1 par tout moyen approprié, par enduction centrifuge, à la tournette, ou encore par sprayage jusqu'à l'épaisseur souhaitée. Typiquement l'épaisseur de résine est comprise entre 10 µm et 1000 µm, et de préférence entre 30 µm et 300 µm. Selon l'épaisseur désirée et la technique de dépôt utilisée la première couche de résine 3 sera déposée en une ou plusieurs fois.

La première couche de résine 3 est ensuite chauffée typiquement entre 90 et 120° C pendant une durée dépendant de l'épaisseur déposée pour évacuer le solvant (étape de pre-bake). Ce chauffage sèche et durcit la résine.

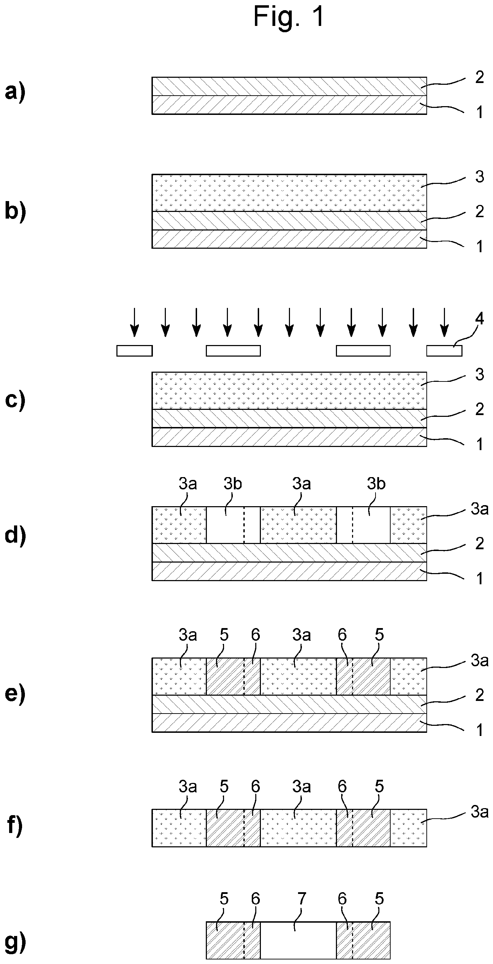

L'étape c) suivante illustrée à la figure 1 consiste à irradier la première couche de résine 3 au moyen d'un rayonnement UV à travers un masque 4 définissant le moule du composant à former et ainsi des zones photopolymérisées 3a et des zones non photopolymérisées 3b.

Selon l'invention, au cours de l'étape c), le masque permet de définir le contour d'un lot de composants 5, ainsi que les contours d'une grille 7 et de ponts de matière 6. Les ponts de matière permettent de relier les composants à la grille au niveau d'une surface non fonctionnelle.

La grille, les ponts de matière et les composants horlogers forment ainsi une grappe de composants à la fin du procédé.

Selon les besoins de l'homme du métier, la grille et/ou les ponts de matière présentent une épaisseur moins élevée que celle des composants.

Avantageusement, les ponts de matière relient les composants à la grille au niveau d'un profil externe non fonctionnel des composants. On entend un composant horloger dont le pourtour extérieur du composant forme une surface fonctionnelle agencée pour coopérer avec d'autres pièces et/ou composants horlogers, un profil (ou une surface) externe non fonctionnel sera donc par analogie un profil qui n'est pas susceptible de coopérer avec un autre composant.

Une étape de recuit (étape de post-bake) de la première couche de résine 3 peut être nécessaire pour compléter la photopolymérisation induite par l'irradiation UV. Cette étape de recuit est effectuée de préférence entre 90°C et 95°C. Les zones photopolymérisées 3a deviennent insensibles à une grande majorité de solvants. Par contre, les zones non photopolymérisées pourront ultérieurement être dissoutes par un solvant.

Ensuite, on dissout les zones non photopolymérisées 3b de la première couche 3 de résine photosensible pour faire apparaître par endroit la couche conductrice 2 du substrat 1. Cette opération est réalisée par dissolution des zones non photopolymérisées 3b au moyen d'un solvant adéquat, tel que le PGMEA (propylène glycol méthyle éthyle acétate). Un moule en résine photosensible photopolymérisée 3a définissant le premier niveau du composant est ainsi réalisé.

L'étape d) suivante illustrée à la figure 1 consiste à déposer dans le moule, par électroformage ou dépôt galvanique, une couche d'un métal à partir de la couche électriquement conductrice 2 jusqu'à former un bloc atteignant préférentiellement une hauteur inférieure à la hauteur du moule, cela permettant une meilleure tenue mécanique lors d'un usinage ultérieur. Par métal dans ce contexte sont bien entendu compris les alliages métalliques. Typiquement, le métal sera choisi parmi l'ensemble comprenant le nickel, le cuivre, l'or ou l'argent, et, comme alliage, l'or-cuivre, le nickel-cobalt, le nickel-fer, le nickel-phosphore, ou encore le nickel-tungstène.

Optionnellement, le procédé comprend une étape e'), après l'étape e) qui consiste à usiner par un procédé mécanique la couche métallique formant les composants 5, et si besoin la couche de résine photopolymérisée 3a, à une épaisseur prédéfinie par l'épaisseur du composant à réaliser.

L'étape f) consiste à libérer la grappe de composants en éliminant par une succession d'étapes de gravure, humide ou sèche, le substrat, les couches conductrices et les couches de résine, opérations familières à l'homme du métier.

Par exemple la couche conductrice 2 et le substrat 1 sont éliminés au moyen d'une gravure humide, ce qui permet de libérer la grappe de composants du substrat 1 sans l'endommager. Notoirement, dans l'exemple d'un substrat en silicium, ce dernier peut être gravé avec une solution à base d'hydroxyde de potassium (KOH).

A l'issue de cette première séquence, on obtient une grappe de composants prise dans la couche de résine comme illustré à l'étape g).

Une 2e séquence consiste à éliminer la première couche 3 et la deuxième couche 6 de résine au moyen de gravures plasma O2, espacées de gravures humides des couches métalliques intermédiaires.

Le procédé peut ensuite comprendre une étape qui consiste à réaliser des opérations d'usinage mécanique telles que des chanfreinages sur les bords de la face visible du composant par exemple, ou encore des taraudages ou des lamages dans le composant. Les opérations dépendront bien évidemment de la géométrie du composant final que l'on souhaite obtenir.

A l'issue de cette étape, la grappe de composants obtenue peut être nettoyée, et les composants de la grappe, toujours solidaires de la grappe, peuvent être soumis à divers traitements décoratifs et/ou fonctionnels, typiquement des dépôts physiques ou chimiques.

Les composants peuvent subir diverses opérations de terminaison de surface alors qu'ils sont encore tenus à la grappe par l'attache de manière précise et aisée. Ainsi les faces avant, arrière et/ ou latérales du composant horloger peuvent être travaillées alors que le composant est toujours maintenu au wafer. L'étape de finition peut consister en un dépôt de couches, de structuration ou de décoration sur les différentes faces du composant horloger. Ces opérations sont à caractère fonctionnel (renfort, tribologique, ...) ou esthétique (coloration, motif), par PVD ou CVD.

Enfin, la dernière étape, consiste à libérer le ou les composants de la grappe formée. Les composants peuvent être séparés de la grappe au moyen de différentes méthodes, telles que la découpe laser, la découpe par étampe, ou la rupture mécanique.

Selon une étape optionnelle, après l'étape b) on effectue une mise à l'épaisseur par une opération d'usinage de la couche de résine 3. Avantageusement, cette opération permet de contrôler finement la géométrie des pièces à l'échelle du substrat 1. Une fois la résine mise d'épaisseur, un traitement thermique est réalisé pour s'affranchir des traces d'usinage.

L'exemple ci-dessus a été écrit pour des composants à un seul niveau. Ce procédé peut également être appliqué à des composants présentant plusieurs niveaux ou étages.

Pour ce faire, un moule multiniveau est réalisé en déposant au moins une deuxième couche conductrice sur les zones photopolymérisées 3a lors de l'étape c). Cette deuxième couche conductrice peut présenter les mêmes caractéristiques que la première couche conductrice 2, à savoir qu'elle est du type Au, Ti, Pt, Ag, Cr, Pd ou un empilement d'au moins deux de ces matériaux, et présente une épaisseur comprise entre 50nm et 500nm.

Ensuite, on dépose une nouvelle couche de résine photosensible sur la deuxième couche conductrice, de manière à recouvrir cette dernière et à remplir les ouvertures dans la couche de résine développée précédemment.

Alternativement, il est également possible d'appliquer le photoresist de la deuxième couche de résine de manière à recouvrir la première couche de résine sans que le photoresist ne pénètre dans les ouvertures formées au début du procédé. Pour obtenir un tel résultat, on peut par exemple utiliser une résine « solide » que l'on peut, par exemple, faire adhérer par laminage.

La deuxième couche de résine est irradiée à travers les ouvertures d'un masque définissant le contour du deuxième niveau de la microstructure désirée. Cette étape nécessite d'aligner le masque avec les ouvertures du premier niveau.

L'homme du métier pourrait également envisager la mise en oeuvre d'une impression 3D pour déposer la deuxième couche conductrice 5.

De telles solutions permettent un dépôt sélectif et plus précis de la deuxième couche électriquement conductrice, et donc de n'avoir aucun dépôt sur les flancs de la résine photopolymérisées 3a.

L'étape suivante illustrée consiste à déposer une deuxième couche de résine photosensible recouvrant la structure résultant de l'étape précédente. La même résine est utilisée lors de cette étape, et l'épaisseur peut être supérieure à celle déposée lors de l'étape a). Généralement l'épaisseur varie en fonction de la géométrie du composant que l'on souhaite obtenir.

L'étape suivante consiste à irradier la deuxième couche de résine à travers un masque définissant un deuxième niveau du composant et dissoudre les zones non irradiées de la deuxième couche de résine photosensible. A la fin de cette étape, on obtient un moule comprenant un premier et un second niveau laissant apparaître par endroit la première couche 2 électriquement conductrice et la deuxième couche électriquement conductrice.

Le procédé de l'invention trouve une application particulièrement avantageuse pour la fabrication de composants pour pièces d'horlogerie, tels que des ressorts, des ancres, des roues, etc. Grâce à ce procédé, on peut obtenir des grappes de composants robustes et qui présentent une bonne fiabilité au niveau des géométries.

Le procédé selon l'invention permet aussi bien de réaliser une grappe globale à l'échelle du « wafer » ou des sous-ensembles de mini-grappes sur un même « wafer ». Par « wafer », on entend la plaque de substrat utilisée pour former la grappe.

Un tel procédé permet également d'utiliser les grappes de composants de manière similaire à la fabrication de composants sur des wafers de silicium.

Bien entendu, la présente invention ne se limite pas à l'exemple illustré, c'est-à-dire la réalisation d'une came, mais est susceptible de diverses variantes et modifications qui apparaîtront à l'homme de l'art.

## Revendications

1. Procédé de fabrication de composants horlogers en lot, **caractérisé en ce qu'**il comprend les étapes suivantes :
a) se munir d'un substrat (1) recouvert d'une couche conductrice d'amorçage (2) ;
b) appliquer sur la couche conductrice (2) de la surface du substrat (1) une couche de résine photosensible (3) ;
c) irradier la couche de résine (3) à travers un masque (4) définissant le contour d'un lot de composants (5), ainsi qu'une grille (7) et des ponts de matière (6), les ponts de matière (6) reliant les composants (5) à la grille (7) au niveau d'une surface non fonctionnelle, la grille, les ponts de matière et les composants horlogers formant une grappe de composants ;
d) dissoudre les zones non irradiées (3b) de la couche de résine photosensible (3) pour faire apparaître par endroit la couche conductrice (2) du substrat et former un moule ;
e) déposer électro-galvaniquement et de manière conforme une couche métallique à partir de la couche conductrice (2), la couche métallique formant la grappe de composants et atteignant le niveau de la surface supérieure de la couche de résine photosensible ;
f) éliminer la couche de résine photosensible et le substrat pour libérer la grappe de composants ainsi formée ;
g) libérer le lot de composants de la grappe.

2. Procédé selon la revendication 1, **caractérisé en ce qu'**il comprend une étape e') entre l'étape e) et l'étape f), au cours de laquelle on aplanit la couche de résine et la couche métallique déposée pour amener la couche de résine et la couche métallique électrodéposée au même niveau.

3. Procédé selon l'une des revendications 1 ou 2, **caractérisé en ce qu'**il comprend :
- après l'étape d), répéter l'étape c) et d) au moins une fois pour obtenir un moule d'au moins deux niveaux ;
- appliquer au moins une autre couche métallique sur l'au moins deuxième niveau du moule.

4. Procédé selon l'une des revendications 1 à 3, dans lequel le moule présente plusieurs niveaux.

5. Procédé selon l'une des revendications 1 à 4, dans lequel le pont de matière (6) présente une épaisseur identique à celle du composant (5).

6. Procédé selon l'une des revendications 1 à 4, dans lequel le pont de matière (6) présente une épaisseur inférieure à celle du composant (5).

7. Procédé de fabrication selon l'une des revendications 1 à 6, **caractérisé en ce qu'**il comprend une étape g) de finition en wafer des faces avant, arrière et/ou latérales du composant horloger (1), l"étape de finition consistant en un dépôt de couches, de structuration et/ou de décoration par exemple.

8. Procédé selon l'une des revendications 1 à 7, dans lequel la grappe de composants horlogers comprend un lot de mêmes composants choisis parmi : roue, came, aiguille, bascule, limaçon, masse oscillante, index ou applique.

9. Procédé selon l'une des revendications 1 à 7, dans lequel la grappe de composants horlogers comprend un lot de composants différents tels que des roues, cames, aiguilles, bascules, masses oscillantes, limaçons, index ou appliques.

10. Lot de composants horlogers (1) obtenu par la mise en oeuvre d'un procédé de fabrication d'un lot de composants horlogers (1) selon l'une des revendications 1 à 9.
